# EUROPEAN PATENT APPLICATION

(11) **EP 4 099 405 A1**
(43) Date of publication of application: **07.12.2022**
(21) Application number: 21382485.7
(22) Date of filing: 31.05.2021
(51) Int. Cl.: H01L 31/05, H01L 31/18

(54) **APPARATUS AND METHOD FOR CONNECTING SOLAR CELLS**

(71) Applicant: Mondragon Assembly, S.Coop, 20500 Aretxabaleta (ES)
(72) Inventor: AGUERRE, Jean-Philippe, 20550 Aretxabaleta (ES); APRAIZ ARENAZA, Aitor, 20550 Aretxabaleta (ES); HERNÁNDEZ MATEO, Xabier, 20550 Aretxabaleta (ES); MARTÍN OROBENGOA, Endika, 20550 Aretxabaleta (ES); GARCÍA ETXEBARRIA, Gorka, 20550 Aretxabaleta (ES)
(74) Representative: Igartua, Ismael

(57) **Abstract**

The invention relates to an apparatus and a method for connecting solar cells and thereby manufacturing solar cell strings. The apparatus (100) comprises a first module (M1) with a first printing station (S2) configured for applying a conductive adhesive on a face of the solar cells; an actuation station (S3) for printing (S2) configured for flipping said solar cells; and a second printing station configured for applying a conductive adhesive by printing on another face of said solar cells. The apparatus (100) comprises a conveying module (M3) for conveying the solar cells with the conductive adhesive on both faces from the first module (M1) to a second module (M2) which is configured for attaching a plurality of solar cells to one another by means of at least one connector.

## Description

### TECHNICAL FIELD

The present invention relates to apparatus and methods for connecting solar cells, which are suitable for manufacturing solar cell strings formed by connecting several individual solar cells in series by means of electrically conductive connectors.

### PRIOR ART

Apparatus or installations for generating solar panels have several stations. Generally, the panels are formed from a plurality of solar cell strings. After said strings are attached in series and/or parallel to one another, the assembly formed as a result of the attachment is framed, giving rise to a solar panel.

Each solar cell string comprises a specific number of solar cells connected in series and the connection between solar cells is made by means of electrically conductive cables (also known as wires or bands) extending parallel to one another (connecting the positive part of one cell with the negative part of the next cell, linking all the cells, and ending in a positive pole and another negative pole which constitute the external connections of the resulting photovoltaic module).

A conventional method for generating a solar cell string is described below. First, a solar cell is arranged on a platform, which is generally a conveyor belt. A tool grips an end of each cable, which is usually wound, and by stretching it out, positions a segment of each unwound cable on said solar cell, such that a first part of the cables is on the solar cell and a second part on the platform. A new solar cell is then arranged on said second part of the cables.

Each cell has specific welding regions which are at least one per cable (or one region on each face and per cable), and the cables are associated with said regions for attachment thereof to the solar cells. Said regions are previously impregnated with an electrically conductive adhesive, so that the cables are kept in place when they are associated with said regions. This attachment is then reinforced, usually by means of heat (by introducing the cells with the cables positioned thereon in a heated area such as an oven, for example).

A known method for applying the conductive adhesive on the solar cells consists of applying the conductive adhesive by way of beads, like the method described in WO2012016103A2, for example, where a tool which moves linearly over the solar cell as it applies the conductive adhesive is used.

Another known method for applying the conductive adhesive on solar cells is based on printing the conductive adhesive on the cell. To that end, a template-like mask arranged on the solar cell is used and the conductive adhesive is applied on the mask. Said mask comprises regions where the conductive adhesive goes through with the help of an actuation element (a brush, for example) acting to direct the conductive adhesive across said regions, said conductive adhesive reaching the required regions of the solar cell based on the design of the mask (of the regions through which the conductive adhesive passes). Said regions can be thereby adjusted or designed based on where the conductive adhesive is to be arranged on the solar cells, this method being a simple and precise method for applying said conductive adhesive.

EP2793275A2 discloses a solar cell connecting apparatus for manufacturing solar cell strings, in which the conductive adhesive is applied by means of printing. The apparatus comprises a first module configured for applying the conductive adhesive on a first face and a second face of one and the same solar cell, a second module configured for attaching the connectors to the solar cells, and a third module configured for conveying the solar cell with the conductive adhesive on both faces from the first module to the second module. The first module comprises a rotary table on which the solar cells are arranged and a printing unit for applying the conductive adhesive on both faces of a solar cell. To apply the adhesive on the two faces, each solar cell must pass through the printing unit twice, i.e., each cell travels over the same path twice on the rotary table (a first time with a face pointing up and a second time with said face pointing down).

### DISCLOSURE OF THE INVENTION

The object of the invention is to provide an apparatus and a method for connecting solar cells and thereby manufacturing solar cell strings, as defined in the claims.

A first aspect of the invention relates to a connecting apparatus comprising a first module configured for applying an electrically conductive adhesive on two opposite faces of the solar cells; a second module configured for attaching at least one connector to the solar cells by means of the conductive adhesive; a conveying module for conveying said solar cells with the conductive adhesive on both faces from the first module to a second module of the apparatus; and a control unit. The second module is configured for attaching at least one connector on the conductive adhesive of the received solar cell and for attaching said solar cell to another solar cell by means of said connector, a solar cell string thus being formed.

The first module comprises a plurality of stations distributed in a forward movement direction and a conveying device configured for causing the solar cells in said first module to move in the forward movement direction and between the different stations of said first module.

The first module comprises a first printing station comprising a first printing unit configured for applying a conductive adhesive by printing on the face of the solar cells that is facing said first printing unit; an actuation station arranged downstream of the first printing station in the forward movement direction and configured for handling the solar cells and causing, with said handling, the flipping of said solar cells; a second printing station which is arranged downstream of the actuation station in the forward movement direction and comprising a second printing unit configured for applying a conductive adhesive by printing on the face of the solar cells that is facing said second printing unit; and an unloading station arranged downstream of the second printing station in the forward movement direction and facing the second module. The conveying module is configured for conveying the solar cells from said unloading station of the first module to the second module, either one at a time or a plurality of solar cells can be conveyed simultaneously.

The arrangement of the different modules and stations of the first module allows solar cell strings to be manufactured with a compact apparatus and in a simple manner. For example, when applying a conductive adhesive by means of printing, the relative positioning between the printing unit in charge of carrying out said application and the solar cell on which said conductive adhesive is applied is important. Having two independent printing units allows the adhesive to be applied on each face of the solar cell, as may be required in each case, conferring greater alignment precision when applying the adhesive on both faces. Furthermore, this also allows different types of conductive adhesives to be applied on both faces if required, and this can be advantageous in some cases because the requirements to be met by the face of the solar cells that will be facing the sun are different from the requirements to be met by the opposite faces, and applying one type of adhesive in each case can result in improved efficiency and/or reduced costs.

Additionally, each solar cell only passes through each station of the first module once, i.e., it travels through the first module only one time, and this can increase the productivity of the apparatus.

A second aspect of the invention relates to a method for connecting solar cells for an apparatus for manufacturing solar cell strings. Solar cell strings are formed by connecting a plurality of individual solar cells in series by means of electrically conductive connectors.

In the method, solar cells are supplied to a first module of the apparatus, and in said first module a conductive adhesive is applied on two opposite faces of the supplied solar cells. The solar cells with conductive adhesive on both faces are conveyed to a second module of the apparatus where at least one connector is associated with said solar cells by means of the cooperation between said connector and the conductive adhesive, so as to be able to attach a plurality of solar cells in series to one another through said connector and thereby form a solar cell string.

In the first module, a conductive adhesive is applied on a first face of the supplied solar cells, the supply of the conductive adhesive being caused through a first mask of a first printing unit of a first printing station of the apparatus, and said solar cells are caused to move in the forward movement direction to an actuation station where said solar cells are flipped. The flipped solar cells move in the forward movement direction to a second printing station of the apparatus where a conductive adhesive is applied on a second face of said solar cells opposite the first face through a second mask of a second printing unit arranged in said second printing station; and said solar cells with adhesive on both faces are caused to move in the forward movement direction to an unloading station of said first module.

Said solar cells are then conveyed from the unloading station of the first module to the second module, said solar cells being arranged on at least one connector present in said second module and at least one connector being arranged on said solar cells in said second module. The mentioned steps can be implemented for solar cells one at a time or for a plurality of solar cells simultaneously.

The advantages described for the apparatus are also obtained with the method.

These and other advantages and features of the invention will become apparent in view of figures and detailed description of the invention.

### DESCRIPTION OF THE DRAWINGS

Figure 1 schematically shows a plan view of an embodiment of a solar cell connecting apparatus .
Figure 2 shows a solar cell string generated with the apparatus of Figure 1.
Figure 3 shows a plurality of connectors connected to a solar cell.
Figure 4 shows a printing unit of a printing station of a first module of the apparatus of Figure 1.
Figure 5 shows an actuation device of an actuation station of the first module of the apparatus of Figure 1.
Figure 6a shows a mask with meshed regions used in a silk-screen printing unit of an embodiment of the apparatus of Figure 1.
Figure 6b shows a mask with grooves used in a silk-screen printing unit of an embodiment of the apparatus of Figure 1.
Figure 7 shows a viewing camera of a supervision station of the first module of the apparatus of Figure 1.
Figure 8 shows a support tool of the apparatus of Figure 1.

### DETAILED DISCLOSURE OF THE INVENTION

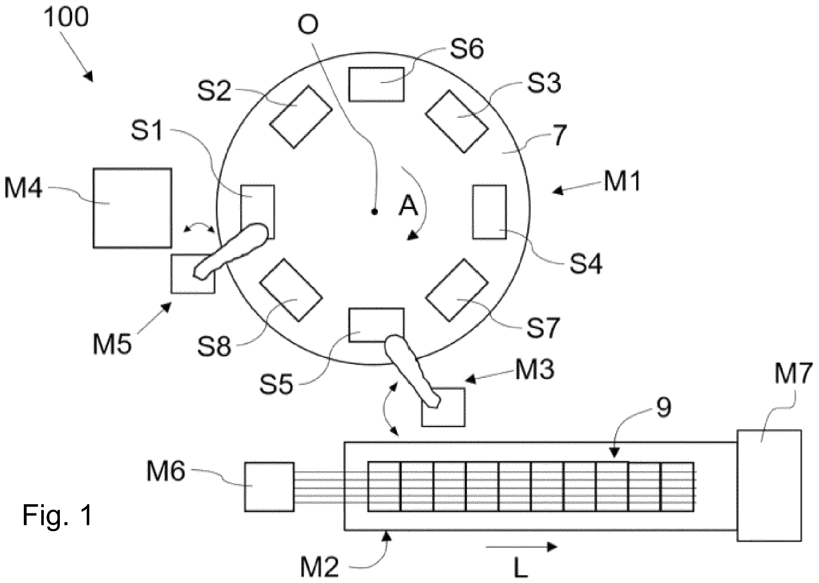

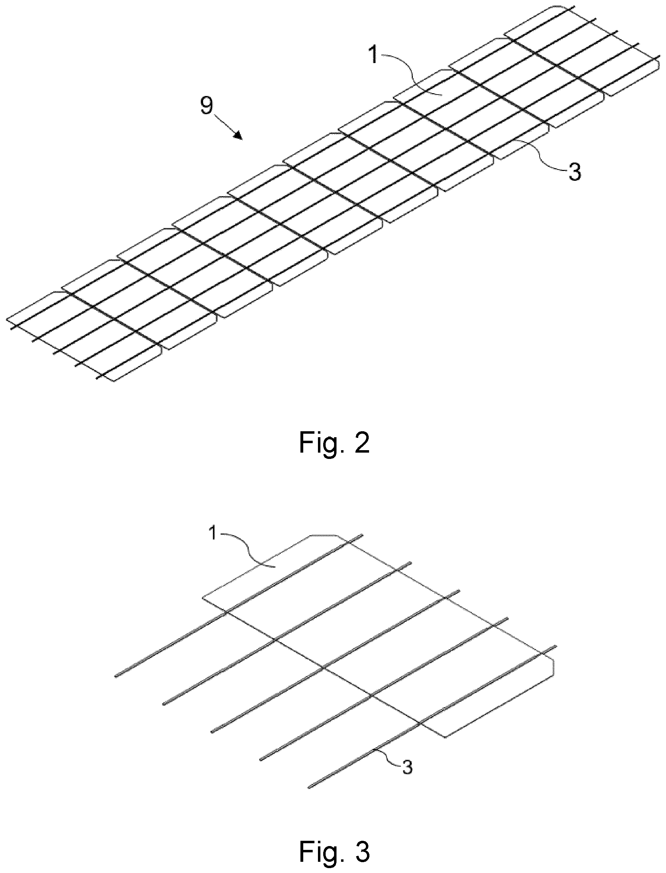

Figure 1 shows an embodiment of an apparatus 100 which is configured for manufacturing solar cell strings 9 like the one shown in Figure 2 by way of example.

A solar cell string 9 is formed by electrically connecting a plurality of individual solar cells 1 in series, the connection being made by means of electrically conductive connectors 3. The connection can be made by means of at least one connector 3, but it is preferably made with at least two connectors 3. When a solar cell string 9 comprises a plurality of connectors 3, said connectors 3 are substantially parallel to one another. The apparatus 100 may comprise a feed module M6 for supplying the connectors 3, and said apparatus 100 is configured for manufacturing solar cell strings 9 of the required length (including the required number of solar cells 1, without limitation). The connectors 3 are likewise attached to the solar cells 3 by means of electrically conductive adhesive.

In recent times, solar cell strings 9 are formed by means of connecting half-solar cells as they have lower resistive losses, and therefore offer higher efficiencies at the module level. In the context of the invention, solar cell 1 can be interpreted as both a conventional solar cell and a half-cell (like the one shown in the figures) or any other type of solar unit which can be used to form solar cell strings 9.

The apparatus 100 comprises a first module M1 configured for applying a conductive adhesive on two opposite faces 1.1 and 1.2 of the solar cells 1 which are supplied to the first module M1, said first module M1 comprising a plurality of stations distributed in a forward movement direction A, that are described below.

The apparatus 100 comprises a loading module M4 from which solar cells 1 are supplied to the first module M1. The solar cells 1 can be fed from the loading module M4 by means of a conveying device M5 such as a robot, an articulated arm, or any other conveying device, which picks up the solar cells 1 in the loading module M4 and unloads them in the first module M1. Preferably, in the loading module M4 the position of at least one region of said solar cells 1 with respect to a predetermined reference position is identified, and if the identified position does not coincide with the reference position, the position of the solar cells 1 is adjusted to make them coincide by means of an adjustment device not depicted in the figures. Therefore, said solar cells 1 are preferably conveyed to the first module M1 in a specific position, such that they are arranged in said first module 1 in a specific position (with a specific orientation). The loading module M4 may further comprise an actuation device for flipping the solar cell 1, such that the solar cells 1 are arranged in the first module M1 with the face that will be facing the sun pointing down. This allows said face to be arranged pointing up in the unloading station S5 of the first module M1, being conveyed in this manner to the second module M2. It is known that it is more appropriate to arrange the connectors 3 on the upper face than on the lower face, and since the upper face is the face that will be facing the sun, the most precise connections are made on said face, which is the most visible face of the solar cell strings 9 (and of the end panels comprising at least part of said solar cell strings 9).

The apparatus 100 comprises a second module M2 configured for associating at least one connector 3 with the solar cells 1 coming from the first module M1, preferably a plurality of connectors 3, and for attaching a plurality of solar cells 1 in series by means of the connector 3, a solar cell string 9 being formed as a result of said attachment. A solar cell 1 coming from the first module M1 is arranged in a first region of the second module 2 and the connector 3 is arranged on said solar cell 1 such that it protrudes at least through one end of said solar cell 1 (see Figure 3), upstream of the first region of the second module 2 with respect to a longitudinal direction L. Said arrangement of the connector 3 is furthermore performed such that part of the connector 3 is arranged on the conductive adhesive deposited on said solar cell 1 in the first module M1, said connector 3 thereby being associated with or attached to said solar cell 1. Once the connector 3 is arranged on the solar cell 1, said solar cell 1 is caused to move forward in the longitudinal direction L in the second module M2 to a second region of said second module M2, such that the part of the connector 3 protruding from the solar cell 1 which has been moved to the second region is now arranged in the first region of said second module M2. Therefore, when arranging a new solar cell 1 in the second module M2 (in the first region of the second module M2), said solar cell 1 is arranged on said connector 3 such that the conductive adhesive coincides with said connector 3 and said solar cell is thereby attached to the preceding solar cell 1. The apparatus 100 may comprise a heating module M7, such as an oven, for example, for hardening the conductive adhesive and therefore strengthening the connections between the connector 3 and the solar cells 1, and thereby forming the solar cell string 9. The heating module M7 can be downstream of the second module M2 in the longitudinal direction L, or the second region of the second module M2 can even be part of said heating module M7.

The operations on the solar cells 1 in the second module M2 have been described considering the solar cells 1 individually, said operations, however, could also be performed for a plurality of solar cells 1 simultaneously. Preferably, the solar cells are conveyed from the unloading station of the first module M1 one at a time and the operations in said second module M2 are performed as described in the preceding paragraph.

The apparatus 100 comprises a conveying module M3 for conveying the solar cells 1 with the conductive adhesive on both faces 1.1 and 1.2 from the first module M1 to the second module M2. The conveying module M3 may comprise a robot or an articulated arm, for example, and can be arranged in the first module M1, in the second module M2, or preferably can be arranged outside both modules M1 and M2.

The apparatus 100 further comprises a control unit 200 configured for controlling the actuation of the different described modules and devices and for controlling them in the described manner.

The first module M1 comprises a conveying device 7 configured for causing the solar cells 1 arranged in the first module M1 to move in the forward movement direction A between the different stations of said first module M1. Preferably, the conveying device 7 comprises a rotary table which rotates with respect to a specific central axis of rotation O and an actuator (not depicted in the figures) to cause the rotation of said rotary table communicated with the control unit 200, the stations of the first module M1 being distributed around said axis of rotation O and the forward movement direction A being a circular direction. This allows having a more compact apparatus 100 since the different stations of the first module M1 do not have to be aligned with one another, and this is also done with a simple configuration. Furthermore, using a rotary table to move the solar cells 1 prevents to the greatest extent possible the handling of the solar cells 1 which are thus safely impregnated with adhesive. The distribution of the stations around said axis of rotation O is preferably homogenous.

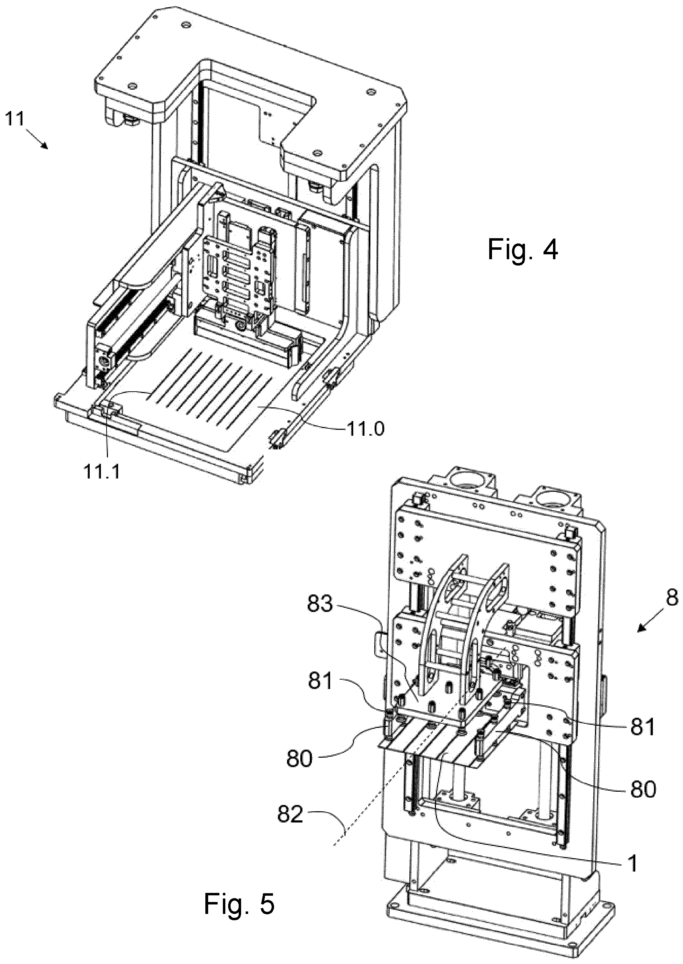

The first module M1 further comprises a loading station S1, which can be facing the loading module M4, in which the solar cells 1 are received; a first printing station S2 downstream of the loading station S1 which comprises a first printing unit 11, shown by way of example in Figure 4 and configured for applying an electrically conductive adhesive by printing on the face 1.1 or 1.2 of the solar cell 1 (or solar cells 1, if there are more than one) that is facing said first printing unit 11 through a first mask 11.0; an actuation station S3 arranged downstream of the first printing station S2 and configured for handling the solar cells 1 coming from the first printing station S2 and causing, with said handling, the flipping of said solar cells 1; a second printing station S4 which is arranged downstream of the actuation station S3 and comprises a second printing unit, not depicted in the figures, which can be similar to the first printing unit 11 and is configured for applying a conductive adhesive by printing on the face 1.1 or 1.2 of the solar cells 1 that is facing said second printing unit through a second mask; and an unloading station S5 which is arranged downstream of the second printing station S4 and can be facing the second module M2, the conveying module M3 being configured for conveying solar cells 1 with the conductive adhesive on both faces 1.1 and 1.2 from said unloading station S5 of the first module M1 to the second module M2, one at a time or a plurality of solar cells 1 simultaneously (as mentioned above).

The apparatus 100 comprises an actuation device 8 in the actuation station S3, like the one shown by way of example in Figure 5, which is configured to perform the flipping. The actuation device 8 comprises at least one arm 80, preferably two, and said arm 80 comprises a plurality of suction elements 81 on two opposite surfaces. The arm 80 can furthermore be configured for moving vertically with respect to the conveying device and for rotating with respect to a specific axis 82 which is preferably horizontal. As a result of the suction elements 81, the arm 80 can suction the solar cells 1 facing it and arranged in the conveying device 7. After this suction, said horizontal arm 80 rotates such that the solar cell 1 (the suction of which is maintained during said rotation) is flipped. Lastly, by means of an additional device 83, said solar cell 1 is released from said arm 80 and is returned, flipped, to the conveying device 7. The additional device 83 suctions the solar cell 1 on the upper face of said solar cell 1 and lowers said solar cell until it is arranged on the conveying device 7 (at which time the additional device releases the solar cell). To that end, before the additional device 83 causes the solar cell 1 to be lowered, the arm 80 releases said solar cell 1. The additional device 83 and the arm 80 are arranged such that the arm 80 is outside the path of the additional device 83 as it moves to position the solar cell 1 on the conveying device 7 (and as it returns to its original position). Preferably, the actuation device 8 comprises two parallel arms 80 separated by a distance greater than the width of the additional device 83, such that the additional device 83 can go through said arms 80 as it moves. The apparatus 100 comprises a structure not depicted in the figures and the actuation device 8 is attached to said structure.

With the actuation on a solar cell 1 in the actuation station S3, the solar cells 1 reach the second printing station S2 such that the second face 1.2 of said solar cell 1, which was not facing the first printing unit 11, is now facing the second printing unit. In this manner, if the first face 1.1 of a solar cell 1 is facing the first printing unit 11, the actuation device causes the second face 1.2 of said solar cell 1 to face the second printing unit. Therefore, with the first printing unit 11, the conductive adhesive would be applied on the first face 1.1 of the solar cell 1, and with the second printing unit, the conductive adhesive would be applied on the second face 1.2 of said solar cell 1.

Preferably, the actuation device is configured for rotating the corresponding solar cell 1, preferably 180°, about its longitudinal axis such that with the first face 1.1 of said solar cell 1 pointing up, after the actuation of the actuation device, the second face 1.2 of said solar cell 1 will be the face pointing up. The printing units 11 are preferably arranged pointing down, i.e., configured for applying the corresponding conductive adhesive on the solar cells 1 arranged under (and facing) them.

The first printing unit 11 comprises a first mask 11.0 on which the adhesive to be applied on the solar cell 1 is arranged, and a first actuation element (not depicted in the figures) acting on the adhesive so that said adhesive goes through the first mask 11.0 and is deposited on the solar cell 1. The first mask 11.0 comprises a configuration such that it allows the passage of adhesive therethrough only through the required regions which will coincide with the regions of the solar cell 1 on which the connectors 3 are to be arranged. The first mask 11.0 can be arranged in a frame 11.4 of the first printing unit 11 and the actuation element may comprise a brush or an equivalent element, for example. Similarly, the second printing unit comprises a second mask. The operation is like the one described for the first printing unit 11.

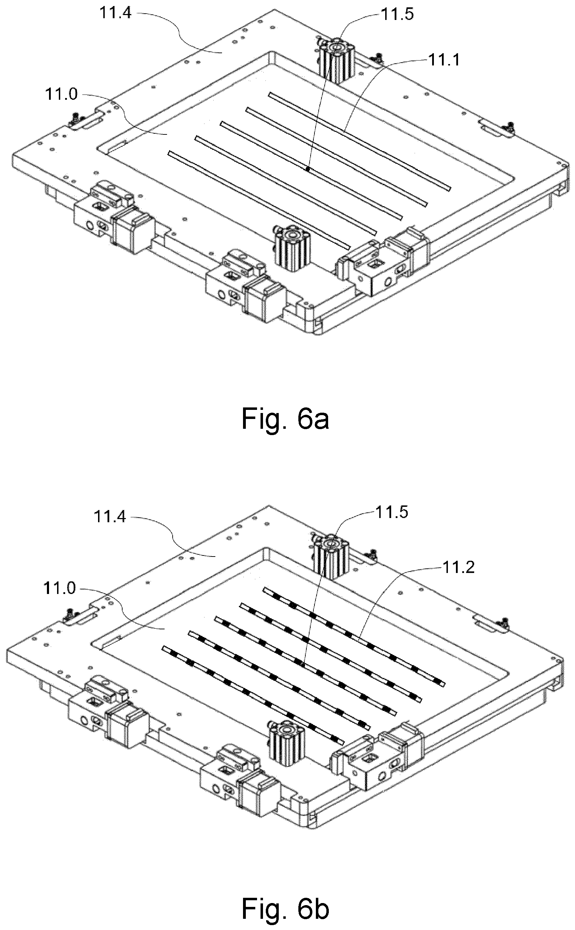

In some embodiments, the printing units are configured for printing the adhesive with the technique known as screen-printing. The masks comprise at least one respective meshed region 11.2, as depicted in Figure 6a, and are configured for allowing the passage therethrough of the conductive adhesive, only through said meshed regions 11.2. The number of meshed regions 11.2 depends on the number of connectors 3 to be used, for example, comprising at least one meshed region 11.2 per connector 3. As a result of this printing technique, great precision is achieved when depositing the adhesive on a solar cell 1 because the meshed regions 11.2 can be designed with the desired size and shape and the conductive adhesive follows said pattern. The fact that the masks 11.0 are meshed masks makes it necessary for the actuation elements to press the conductive adhesive against the masks so that said conductive adhesive goes through said meshed regions 11.2, but due to the properties conferred by the meshing, said masks exhibit a range of flexibility and are hard-wearing, the breakage thereof due to said pressure being prevented. In contrast, the meshing means a smaller passage for the conductive adhesive and it furthermore means a risk of said passages getting clogged, and this may make it necessary to implement periodic mask cleaning processes.

In other embodiments, to solve this problem, the printing units are configured for printing the conductive adhesive with the technique known as stencil printing. The masks 11.0 comprise at least one respective groove 11.1, as depicted in Figure 6b, and are configured for allowing the passage therethrough of the conductive adhesive, only through the corresponding groove 11.1. This facilitates the passage of the adhesive through the masks 11.0 and allows the passage of a larger amount of conductive adhesive, compared with the technique known as screen-printing, and thus furthermore requires a lower pressure (or the absence of pressure) on said masks 11.0. The number of grooves 11.1 depends on the number of connectors 3 to be used, for example, comprising at least one groove 11.1 per connector 3. As a result of this printing technique, great precision is achieved when depositing the adhesive on a solar cell 1 because the grooves can be designed with the desired size and shape and the adhesive follows said pattern, and additionally, the risk of clogging the grooves 11.1 is greatly reduced (or eliminated), with the need for cleaning said masks being avoided (or with a much lower cleaning frequency being required).

In other embodiments, one of the printing units is configured for printing the conductive adhesive with the technique known as screen-printing and the other printing unit is configured for printing the conductive adhesive with the technique known as stencil printing.

In some embodiments, the first module M1 comprises a supervision station S6 downstream of the first printing station S2 in the forward movement direction A, which is configured for detecting the conductive adhesive arranged on the solar cell 1 (or solar cells 1, if there are more than one) in said first printing station S2 and for transmitting said detection to the control unit 200. The apparatus 100 comprises adjustment means for adjusting the relative position between the mask 11.0 and the solar cell 1 based on said detection, such that if it detects an incorrect position of the conductive adhesive in a solar cell 1, said arrangement can be corrected for subsequent solar cells 1.

Preferably, the adjustment means are comprised in the first printing unit 11 and are configured for moving the mask 11.0. The adjustment means comprise an actuator communicated with and controlled by the control unit 200, and at least one actuation element pushing against the mask to move it when it is caused to do so by the actuator. Preferably, the adjustment means comprise a plurality of independently controlled (each with its actuator) actuation elements facing different sides of the mask 11.0, where said mask 11.0 can be moved so that it adopts different orientations. Preferably, the mask 11.0 rotates with respect to a central point 11.5, actuated by the actuation elements. This allows the arrangement of the adhesive on the solar cell 1 in the first printing station S2 to be corrected if it is determined in the supervision station S6 that said adhesive has not been applied correctly, so that said arrangement of the adhesive in subsequent solar cells 1 is correct. This correction is made by moving only the mask 11.0, which facilitates adjustment.

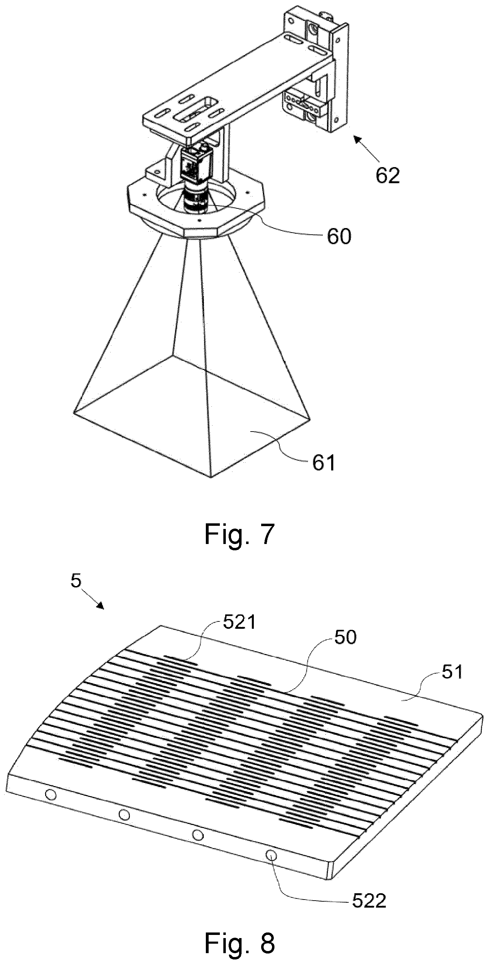

The supervision station S6 may comprise, as shown by way of example in Figure 7, a viewing camera 60 facing the conveying device 7, such that the solar cell 1 is arranged in the field of view 61 of said viewing camera 60 when said solar cell 1 is arranged in the supervision station S6. The image obtained with the viewing camera 60 is sent to the control unit 200 which determines if the conductive adhesive is in the required position. The apparatus 100 comprises a structure not depicted in the figures and the viewing camera 60 is attached to said structure by means of a support 62.

The first module M1 may comprise a second supervision station S7 downstream of the second printing station S4 in the forward movement direction A, which is configured for detecting the adhesive arranged on the solar cell 1 (or solar cells 1, if there are more than one) in the second printing station S4 and for transmitting said arrangement to the control unit 200. The apparatus 100 may comprise adjustment means for adjusting the relative position between the second mask and the solar cell 1, which are preferably similar to the adjustment means described for the first printing unit 11.

In some embodiments in which the apparatus 100 comprises at least one supervision station S6, S7, the control unit 200 is configured for determining whether the arrangement of the adhesive on the solar cell 1 (or solar cells 1, if there are more than one) is correct and for causing the conveying module M3 to convey the solar cells 1 with the conductive adhesive on both faces 1.1 and 1.2 from the unloading station S5 of the first module M1 to the second module M2 if said arrangement is correct and causing said conveying module M3 to convey the solar cells 1 with the conductive adhesive on both faces 1.1 and 1.2 from the unloading station S5 of the first module M1 to a waste module far from the first module M1 and the second module M2 if said arrangement is incorrect. The waste module can be a tray for waste, for example. Greater efficiency in the elements of the apparatus 100, which only act when applicable, is thereby obtained in these embodiments.

Preferably, the first module M1 comprises a support tool 5 configured for supporting at least one solar cell 1 when said solar cell 1 is arranged in said first module M1 and as it is being conveyed in said first module M1, said holding tool 5 being configured for moving together with the solar cell 1 in said first module M1 in the forward movement direction A. Preferably, said support tool 5 is attached to the conveying device 7 (to the rotary table, where appropriate). Said first module M1 may comprise a cleaning station S8 downstream of the unloading station S5 in the forward movement direction A, and said cleaning station S8 comprises a cleaning device for removing remnants of the adhesive from the support tool 5, such that said support tool 5 is clean to receive new solar cells 1. The cleaning device may comprise, for example, a roller or a similar element which is passed over the surface of the support tool 5 to clean it.

The support tool 5 can be configured for supporting one solar cell 1 or a plurality of solar cells 1 simultaneously, and can be attached to the conveying device 7 of said first module M1 (in a detachable manner, for example).

Each printing unit is configured for depositing the adhesive on the solar cell 1 in the form of longitudinal bands. As shown in Figure 8, the support tool 5 can have a longitudinal groove 50 for each adhesive band on an upper surface 51 on which the solar cell 1 is arranged, such that once at least one band is deposited on the first face 1.1, when said solar cell 1 is flipped, said band is arranged on said groove 50 and the conductive adhesive is kept in place.

The support tool 5 can be configured for supporting the solar cell 1 by means of suction, i.e., it draws the solar cell onto its upper surface 51 by means of suction, thus keeping it in place. To that end, said support tool 5 comprises at least one suction conduit through which suction on the solar cell 1 is generated. Said suction conduit has a first access 521 on the upper surface 51 whereby the solar cell 1 is drawn in and kept in place, and a second access 522 through which suction is applied. Said second access 522 can be on a side, for example.

A second aspect of the invention relates to a method for connecting solar cells for an apparatus 100 for manufacturing solar cell strings 9. Solar cell strings 9 are formed by connecting individual solar cells 1 by means of electrically conductive connectors 3.

The method comprises supplying at least one solar cell 1 to a first module M1 of the apparatus 100; applying a conductive adhesive, preferably by way of longitudinal bands, on two opposite faces 1.1 and 1.2 of the supplied solar cell 1, in said first module M1; conveying the solar cell 1 with conductive adhesive on both faces 1.1 and 1.2 to a second module M2 of the apparatus 100; and associating at least one connector 3 with the solar cell 1 coming from the first module M1 which is associated with a preceding solar cell 1 by means of the conductive adhesive, to thereby form a solar cell string 9 in said second module M2.

In the first module M1, a conductive adhesive is applied on a first face 1.1 of said solar cell 1 in a first printing station S2 like the one described above, where a conductive adhesive is applied on a first face 1.1 of said solar cell 1; said solar cell 1 with the adhesive on said first face 1.1 is caused to move in the forward movement direction A to an actuation station S3 where said solar cell 1 is flipped (rotated 180°); said flipped solar cell 1 is caused to move in the forward movement direction A to a second printing station S4 like the one described above, where a conductive adhesive is applied on a second face 1.2 of said solar cell 1 opposite the first face 1.1; and said solar cell 1 is caused to move in the forward movement direction A from said second printing station S4 to an unloading station S5 of said first module M1.

From the unloading station S5, said solar cell 1 is conveyed to the second module M2 (to a first region of the second module M2), and in said second module M2, at least one connector 3 is arranged on said solar cell 1 arranged in said first region. Said solar cell 1 is then caused to move linearly to a second region as described for the apparatus 100 of the invention, such that part of the connector 3 protruding from the solar cell 1 is in the first region of said second module M2. Therefore, when a new solar cell 1, coming from the first module M1, is arranged in the first region of the second module M2, it is arranged on said connector 3, said new solar cell 1 being attached to the preceding solar cell 1, and the solar cell string 9 thus being formed.

The apparatus 100 may comprise a heating module M7, such as an oven, for example, for hardening the conductive adhesive and therefore strengthening the connections between the connector 3 and the solar cells 1, and thereby forming the solar cell string 9. The heating module M7 can be downstream of the second module M2 in the longitudinal direction L, or the second region of the second module M2 can even be part of said heating module M7.

Once the adhesive is applied on the solar cell 1 in the first printing station S2, in the method said solar cell 1 can be caused to move in the forward movement direction A to a supervision station S6 which is arranged downstream of the first printing station S2 in the first module M1. Operations relating to the supervision station S6, including the operation of the associated adjustment means, have already been described above for the apparatus 100 and are likewise applicable to the method.

Once the adhesive is applied on the solar cell 1 in the second printing station S4, in the method said solar cell 1 can be caused to move in the forward movement direction A to a second supervision station S7 which is arranged downstream of the second printing station S4 in the first module M1. Operations relating to the supervision station S7, including the operation of the associated adjustment means, have already been described above for the apparatus 100 and are likewise applicable to the method.

If the method includes a detection of the conductive adhesive likes those that have been described, conveying only the solar cell 1, the adhesive of which is correctly arranged, to the second module M2 may also constitute an option in the method. Otherwise, the solar cell 1 with an incorrect adhesive arrangement can be conveyed to a waste module like the one described above, for example, which is preferably far from the first module M1 and the second module M2 (not integrated in any of modules M1 and M2).

Preferably, the solar cell 1 which is supplied to the first module M1 is associated with a support tool 5 arranged in said first module M1, and said solar cell 1 is conveyed by said first module M1 supported by said support tool 5 as described above for the apparatus 100. For these cases, in the method the support tool 5 can be caused to move from the unloading station S5 to a cleaning station S8 arranged downstream of the unloading station S5, once the corresponding solar cell 1 has been unloaded from the first module M1 (once it has been conveyed to the second module M2), and said support tool 5 is cleaned in said cleaning station S8 to remove the adhesive adhered to said support tool 5. Once the cleaning tool 5 has been cleaned, said support tool 5 is moved in the forward movement direction A to the loading station S1 of the first module M1. The support tool 5 used in the method can be the one described for the apparatus 100.

The method may further comprise flipping the solar cell 1 in the loading module M4, such that the solar cells 1 are arranged in the first module M1 with the face that will be facing the sun pointing down. This allows said face to be arranged pointing up in the unloading station S5 of the first module M1, being conveyed in this manner to the second module M2. It is known that it is more appropriate to arrange the connectors 3 on the upper face than on the lower face, and since the upper face is the face that will be facing the sun, the most precise connections are made on said face, which is the most visible face of the solar cell strings 9 (and of the end panels comprising at least part of said solar cell strings 9).

Furthermore, in the method, before supplying a solar cell 1 to the first module M1, the position of at least one region of said solar cell 1 with respect to a predetermined reference position in the loading module M4 can be identified, and if the identified position does not coincide with the reference position, the position of the solar cell 1 is adjusted to make them coincide. This facilitates supporting the solar cell 1 in the support tool 5, or in the first module if there is no support element 5, in a required position, so that the subsequent steps are preformed correctly.

The different steps described for the method can be performed continuously, such that a solar cell string 9 is formed in a continuous and automatic manner. Furthermore, once a solar cell 1 is moved from the loading station S1 of the first module M1, another solar cell 1 can be supplied to said loading station S1, such that the first module M1 can have a plurality of solar cells 1 simultaneously distributed among the different stations of said first module M1.

The steps of the method carried out in the first module M1 can be implemented in solar cells 1 individually or can be implemented for a plurality of solar cells 1 simultaneously. The same is true with the steps carried out in the loading module M4, in the second module M2, and/or in the heating module M7. The solar cells 1 can also be conveyed between modules one at a time or a plurality of solar cells 1 can be conveyed simultaneously.

The method is suitable for being implemented in an apparatus 100 like the one described for the first aspect of the invention, in any of its embodiments and/or configurations, the method comprising an embodiment and/or configuration according to the embodiment and/or configuration of said apparatus 100. Therefore, everything that has been mentioned for the apparatus 100 which has not been described for the method is also valid for said method. Similarly, the apparatus 100 of the first aspect of the invention is suitable for supporting the method of the second aspect of the invention, in any of its embodiments and/or configurations, said apparatus 100 comprising an embodiment and/or configuration according to the embodiment and/or configuration of the method. Therefore, everything that has been mentioned for the method which has not been described for the apparatus 100 is also valid for said apparatus 100.

## Claims

1. Solar cell connecting apparatus for manufacturing solar cell strings formed by connecting individual solar cells by means of electrically conductive connectors, said apparatus comprising a first module (M1) with a plurality of stations distributed in a forward movement direction (A) and configured for applying a conductive adhesive on two opposite faces (1.1, 1.2) of at least one solar cell (1); a second module (M2) configured for associating at least one connector (3) with each face (1.1, 1.2) of the solar cells (1) coming from the first module (M1) by means of the conductive adhesive, and for attaching a plurality of solar cells (1) in series with said associated connectors (3) by means of said connectors (3), a solar cell string (9) being formed; a conveying module (M3) for conveying the solar cells (1) with the conductive adhesive on both faces (1.1, 1.2) from the first module (M1) to the second module (M2); and a control unit (200), the first module (M1) comprising an unloading station (S5) facing the second module (M2), the conveying module (M3) being configured for conveying the solar cells (1) from said unloading station (S5) of the first module (M1) to the second module (M2); and a conveying device (7) configured for causing the solar cell (1) to move in the forward movement direction (A) between the different stations of said first module (M1), **characterized in that** the first module (M1) further comprises a first printing station (S2) which comprises a first printing unit (11) with a first mask (11.0) and which is configured for applying a conductive adhesive by printing on the face of the solar cells (1) which are facing said first printing unit (11) through said first mask (11.0); an actuation station (S3) arranged downstream of the first printing station (S2) in the forward movement direction (A) and configured for handling the solar cells (1) coming from the first printing station (S2) and causing, with said handling, the flipping of said solar cells (1); and a second printing station (S4) which is arranged downstream of the actuation station (S3) and upstream of the unloading station (S5) in the forward movement direction (A), comprising a second printing unit with a second mask and configured for applying a conductive adhesive by printing on the face of the solar cells (1) which are facing said second printing unit, through said second mask.

2. Solar cell connecting apparatus according to claim 1, wherein the first module (M1) comprises a supervision station (S6) which is arranged downstream of the first printing station (S2) and upstream of the second printing station (S4) in the forward movement direction (A) and is configured for detecting the conductive adhesive that has been arranged on the solar cells (1) in said first printing station (S2) and for transmitting said arrangement to the control unit (200), the apparatus (100) comprising adjustment means for adjusting the relative position between the first mask (11.0) of the first printing unit (11) of said first printing station (S2) and the solar cells (1) which are arranged in said first printing station (S2), and the control unit (200) being suitable for acting on the adjustment means and configured for performing said adjustment based on the information received from the supervision station (S6), such that the relative position between the first mask (11.0) of said first printing unit (11) and the solar cells (1) is adjusted based on said information.

3. Solar cell connecting apparatus according to claim 1 or 2, wherein the first module (M1) comprises a supervision station (S7) which is arranged downstream of the second printing station (S4) in the forward movement direction (A) and is configured for detecting the conductive adhesive that has been arranged on the solar cells (1) in said second printing station (S4) and for transmitting said arrangement to the control unit (200), the apparatus (100) comprising adjustment means for adjusting the relative position between the second mask of the second printing unit of said second printing station (S4) and the solar cells (1) which are arranged in said second printing station (S4), the control unit (200) being suitable for acting on said adjustment means and configured for performing said adjustment based on the information received from said supervision station (S7), such that the relative position between the second mask and the solar cells (1) is adjusted based on said information.

4. Solar cell connecting apparatus according to claim 2 or 3, wherein to adjust the relative position between the corresponding mask (11.0) and the solar cells (1), the adjustment means are configured for moving said mask (11.0).

5. Solar cell connecting apparatus according to any of claims 1 to 4, comprising a support tool (5) attached to the conveying device (7) of the first module (M1) and configured for supporting the solar cells (1) as they are being conveyed in the first module (M1), said first module (M1) comprising a cleaning station (S8) downstream of the unloading station (S5) in the forward movement direction (A) and said cleaning station (S8) comprising a cleaning device to remove remnants of the conductive adhesive from the support tool (5).

6. Solar cell connecting apparatus according to any of claims 1 to 5, wherein the mask (11.0) of a printing unit (11) comprises at least one groove (11.1) and is configured for allowing the passage therethrough of the conductive adhesive, only through said groove (11.1).

7. Solar cell connecting apparatus according to any of claims 1 to 5, wherein the mask (11.0) of a printing unit (11) comprises at least one meshed region (11.2) and is configured for allowing the passage therethrough of the conductive adhesive, only through said meshed region (11.2).

8. Solar cell connecting apparatus according to any of claims 1 to 7, comprising a loading module (M4) and a conveying device (M5) configured for supplying the solar cells (1) to the first module (M1) from said loading module (M4), said loading module (M4) preferably facing a loading station (S1) of the first module (M1) which receives the solar cells (1) coming from the loading module (M4), and said loading module (M4) comprising an actuation unit configured for identifying the position of at least one region of said solar cells (1) with respect to a predetermined reference position, and for adjusting the position of said solar cells (1) to make the position of the solar cells (1) coincide with the reference position if the identified position does not coincide with the reference position.

9. Method for connecting solar cells to manufacture solar cell strings formed by connecting individual solar cells (1) by means of electrically conductive connectors (3), wherein at least one solar cell (1) is supplied to a first module (M1) of a solar cell connecting apparatus (100); a conductive adhesive is applied on two opposite faces (1.1, 1.2) of the supplied solar cell (1) in said first module (M1); the solar cell (1) with adhesive on both faces (1.1, 1.2) is conveyed to a second module (M2) of the apparatus (100); and, in said second module (M2), at least one connector (3) is associated with the solar cell (1) coming from the first module (M1) which is associated with a preceding solar cell (1), so as to attach said solar cells (1) in series by means of said connector (3) and thereby form a solar cell string (9), **characterized in that** in the first module (M1), in a first printing station (S2) a conductive adhesive is applied on a first face (1.1) of the supplied solar cell (1) through a first mask (11.0) of a first printing unit (11) of said first printing station (S2); said solar cell (1) is caused to move in a forward movement direction (A) to an actuation station (S3) where said solar cell (1) is flipped; said flipped solar cell (1) is caused to move in the forward movement direction (A) to a second printing station (S4) where a conductive adhesive is applied on a second face (1.2) of said solar cell (1) opposite the first face (1.1) through a second mask of a second printing unit of said second printing station (S4); said solar cell (1) with adhesive on both faces (1.1, 1.2) is caused to move in the forward movement direction (A) to an unloading station (S5) of said first module (M1); and said solar cell (1) with conductive adhesive on both faces (1.1, 1.2) is conveyed from said unloading station (S5) to the second module (M2), said solar cell (1) being arranged on at least one connector (3) present in said second module (M2) and at least one connector (3), in said second module (M2), being arranged on said solar cell (1).

10. Method for connecting solar cells according to claim 9, wherein once the conductive adhesive is applied on the solar cell (1) in the first printing station (S2), said solar cell (1) is caused to move in the forward movement direction (A) to a supervision station (S6), and, in said supervision station (S6), the arrangement of the conductive adhesive which has been applied on the solar cell (1) in the first printing station (S2) is detected and the relative position between the first mask (11.0) and the solar cell (1) is adjusted based on said detection.

11. Method for connecting solar cells according to claim 9 or 10, wherein once the conductive adhesive is applied on the solar cell (1) in the second printing station (S4), said solar cell (1) is caused to move in the forward movement direction (A) to a supervision station (S7), and, in said supervision station (S7), the arrangement of the conductive adhesive which has been applied on the solar cell (1) in the second printing station (S4) is detected, and the relative position between the second mask and the solar cell (1) is adjusted based on said detection.

12. Method for connecting solar cells according to claim 10 or 11, wherein the corresponding mask (11.0) is caused to move in order to adjust the relative position between a mask (11.0) and the solar cell (1).

13. Method for connecting solar cells according to any of claims 10 to 12, wherein a supervision station (S6, S7) transmits the performed detection to a control unit (200) of the apparatus (100), and said control unit (200) determines, based on said received information, whether the arrangement of the conductive adhesive on the corresponding face (1.1, 1.2) of the solar cell (1) is correct or incorrect and causes a solar cell (1) to be conveyed from the first module (M1) to the second module (M2) if it determines that said arrangement is correct, and causes said solar cell (1) to be conveyed to a waste module far from the first module (M1) and the second module (M2) if it determines that said arrangement is incorrect.

14. Method for connecting solar cells according to any of claims 9 to 13, wherein the solar cell (1) which is supplied to the first module (M1) is associated with a support tool (5) arranged in said first module (M1) and said solar cell (1) is conveyed by said first module (M1) supported by said support tool (5), said support tool (5) being caused to move in the forward movement direction (A) in the first module (M1) from the unloading station (S5) to a cleaning station (S8) arranged downstream of the unloading station (S5), once said solar cell (1) has been unloaded from the first module (M1), and said support tool (5) being cleaned in said cleaning station (S8) to remove the adhesive adhered to said support tool (5).

15. Method for connecting solar cells according to any of claims 9 to 14, wherein before supplying a solar cell (1) to the first module (M1), the position of at least one region of said solar cell (1) with respect to a predetermined reference position is identified, and if the identified position does not coincide with the reference position, the position of the solar cell (1) is adjusted to make them coincide.
